# EUROPEAN PATENT APPLICATION

(11) **EP 2 119 683 A1**
(43) Date of publication of application: **18.11.2009**
(21) Application number: 08710683.7
(22) Date of filing: 31.01.2008
(51) Int. Cl.: C03C 4/12, C03C 3/12, G02B 1/00, H01L 33/00, H01S 5/02

(54) **OPTICAL ELEMENT, TITANIUM OXIDE GLASS USED FOR THE OPTICAL ELEMENT, AND LIGHT EMITTING METHOD AND LIGHT AMPLIFYING METHOD USING TITANIUM OXIDE GLASS**

(30) Priority: 02.02.2007 JP 2007024393
(71) Applicant: Japan Aerospace Exploration Agency, Chofu-shi, Tokyo 182-8522 (JP); Nippon Sheet Glass Company Limited, Tokyo 108-6321 (JP)
(72) Inventor: KITTAKA, Shigeo, Tokyo 108-6321 (JP); TSUDA, Masahiro, Tokyo 108-6321 (JP); YONO, Kentei, Tsukuba-shi Ibaraki 305-8505 (JP); MASUNO, Atsunobu, Tsukuba-shi Ibaraki 305-8505 (JP); ARAI, Yasutomo, Tsukuba-shi Ibaraki 305-8505 (JP)
(74) Representative: Hart-Davis, Jason
(86) International application number: PCT/JP2008/051585
(87) International publication number: WO 2008/093810

(57) **Abstract**

An optical element of the present invention exhibits at least one of an upconversion emission characteristic and a light amplifying characteristic when irradiated with an excitation light. The optical element includes a bulk glass that contains titanium oxide as a main component, and the glass further contains a rare earth element. As the rare earth element, at least one element of Er and Yb, or a combination of Yb and Tm preferably is used, for example.

## Description

### Technical Field

The present invention relates to an optical element that exhibits an upconversion emission characteristic and/or a light amplifying characteristic, a titanium-containing oxide glass used for the optical element, and a light emitting method and a light amplifying method using the titanium containing oxide glass.

### Background Art

It is known that in rare earth elements and some transition elements, atoms thereof emit fluorescent lights when the atoms excited to a high energy level by being irradiated with an excitation light are relaxed to a lower energy level. In a usual fluorescent light emission, a light with a longer wavelength than that of an excitation light is emitted. In some cases, however, a light with a shorter wavelength than that of an excitation light is emitted, which is called upconversion emission. For example, in the upconversion emission, the excited atoms absorb the light again before being relaxed to a lower energy level and are excited to a further higher energy level, and a light is emitted when the atoms transit from that high energy state to a low energy state such as a ground state. The technology of upconversion emission has been applied to laser oscillation and optical amplifiers under a condition (inverted population) in which the density of the higher energy level atoms is higher than that of the lower energy level atoms. These rare earth elements etc. are used while being dispersed in a medium such as glass, crystal, and ceramics (see JP 5 (1993)-319856 A, JP 7 (1995)-162062 A, and JP 7 (1995)-162063 A, for example).

Glass materials are transparent, and unlike crystalline materials, a shape thereof can be changed by cutting or polishing operations without taking crystal orientation into consideration. Moreover, since glass per se also can be utilized as a lens and a prism, it is excellent as a material for optical elements. Particularly, oxide glasses containing SiO₂ as a glass skeleton have high durability, and thereby they are used widely in various technical fields.

Even when a glass containing SiO₂ as a skeleton is doped with a rare earth element, the upconversion emission to be obtained is very weak. This is because the SiO₂ skeleton has a large lattice vibration energy, and most of the excited electrons lose energy in the form of heat. This phenomenon is called non-radiative relaxation. As a result, the energy to be used for upconversion is reduced, lowering the emission intensity significantly.

The SiO₂-skele glass doped with Er has been put in practical use as a core of optical fiber amplifiers. However, when the concentration of Er is high, a signal light is absorbed more than it is amplified. For this reason, the Er concentration needs to be 1% or less usually. In order to attain a sufficient amplifying effect, the fiber needs to have a length of several to tens of meters.

In order to increase the intensity of the upconversion emission, it is effective to decrease the energy of the lattice vibration. More specifically, it is effective to allow the medium with the rare earth element etc. dispersed therein to contain a heavy element. For example, doping ZBLAN (ZrF₄-BaF₂-LaF₃-AIF₃-NaF), a kind of fluoride glass, with Er makes it possible to attain a high intensity light emission. In amplifiers using a fluoride glass fiber, the rare earth concentration can be increased. Thus, a sufficient light amplifying effect can be obtained even with 1 m or less of fiber length.

However, fluoride glasses such as ZBLAN have a problem in that they have poor durability and deteriorate easily Therefore, in the case of an amplifier fiber formed of fluoride glass, a design scheme is needed, such as storing the fiber in a casing with an airtight structure so as to prevent the fiber from contacting with air.

### Disclosure of Invention

An object of the present invention is to provide a highly durable optical element having an upconversion emission characteristic and/or a light amplifying characteristic. Another object of the present invention is to provide a titanium-containing oxide glass used to obtain the optical element. Still another object of the present invention is to provide a light emitting method and a light amplifying method using the titanium-containing oxide glass.

The optical element of the present invention is an optical element that exhibits at least one of an upconversion emission characteristic and a light amplifying characteristic when irradiated with an excitation light. The optical element of the present invention includes a bulk glass that contains titanium oxide as a main component. The glass further contains a rare earth element.

The titanium-containing oxide glass of the present invention is a bulk glass that contains titanium oxide as a main component, and further contains a rare earth element.

In this specification, the term "bulk" is meant to exclude forms such as a flake form or a powder form, and the term refers to forms whose minimum dimension (the smallest dimension passing the center of gravity) is 10 µm or more (preferably 50 µm or more). As will be described later, titanium-containing oxides containing titanium oxide as a main component are crystallized very easily. Thus, bulk, vitreous titanium-containing oxides have not obtained so far, although vitreous titanium-containing oxides in a form of a thin film or powder may have been obtained. This is the reason why a bulk glass is specified here.

The light emitting method of the present invention is a light emitting method using the titanium-containing oxide glass of the present invention. The light emitting method of the present invention is a method in which the titanium-containing oxide glass is irradiated with an excitation light so that light emission by an upconversion effect of the titanium-containing oxide glass is attained.

The light amplifying method of the present invention is a light amplifying method using the titanium-containing oxide glass of the present invention. The light amplifying method of the present invention is a method in which the titanium-containing oxide glass is irradiated with an excitation light so that a light amplifying effect of the titanium-containing oxide glass amplifies a light that is incident on the titanium-containing oxide glass.

The glass containing titanium oxide as a main component used in the optical element of the present invention may contain a high concentration of rare earth element. Thus, the optical element of the present invention can attain a high intensity upconversion emission effect and/or a sufficient light amplifying effect. Furthermore, the glass containing titanium oxide as a main component used in the optical element of the present invention has a sufficient durability, making the optical element highly durable.

### Brief Description of Drawings

Fig. 1 is a schematic view showing an example of a gas levitation apparatus used in a method for producing the titanium-containing oxide glass included in the optical element of the present invention.
Fig. 2 is a schematic view showing an optical resonator as an example of the optical element of the present invention.
Fig. 3A is a schematic view showing a light-emitting device as an example of the optical element of the present invention.
Fig. 3B is a schematic view showing a light-emitting device as an example of the optical element of the present invention.
Fig. 4 is a chart representing the results of differential thermal analysis (DTA) conducted on the samples produced in Example 1.
Fig. 5 is a view for illustrating a method for measuring refractive index.
Fig. 6 is a schematic view of an apparatus for measuring the upconversion emission of samples.
Fig. 7 shows the results of emission spectra measurements taken by a Raman microscopic apparatus.
Fig. 8 is a chart representing a result of differential thermal analysis (DTA) conducted on the sample produced in Example 2.

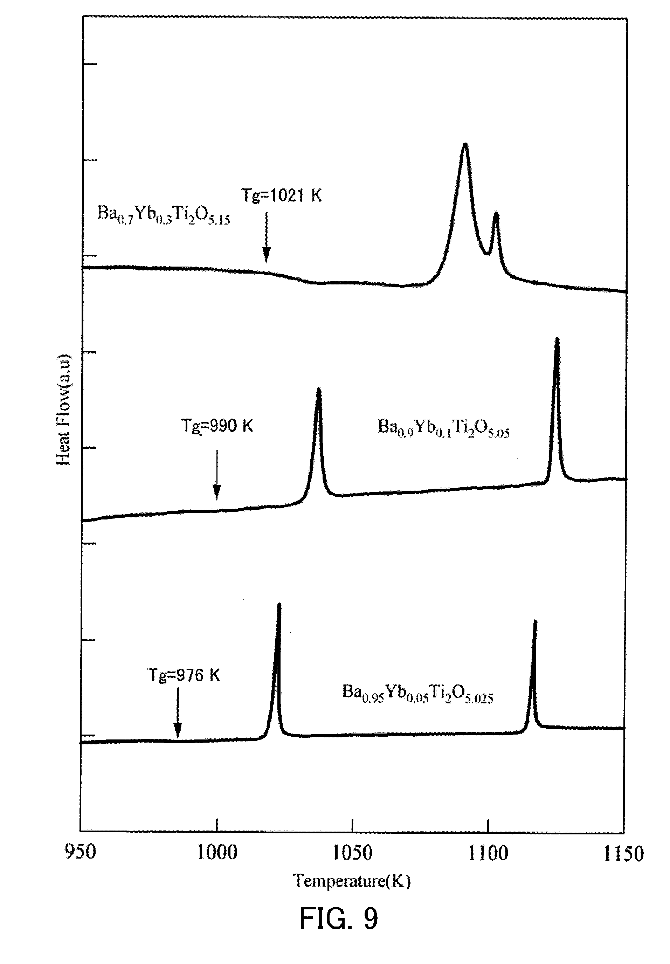

Fig. 9 is a chart representing results of differential thermal analysis (DTA) conducted on the samples produced in Example 3.
Fig. 10 is a graph showing an emission spectrum of Sample 4-5.
Fig. 11 is a schematic view of an apparatus for observing light amplification of samples.
Fig. 12 is a view showing ASE intensities of samples irradiated only with an excitation beam.
Fig. 13 is a view showing signal light intensities.

### Best Mode for Carrying Out the Invention

Hereinafter, embodiments of the present invention will be described in detail.

### <Optical element>

The optical element of the present embodiment is formed using a bulk glass. The glass contains titanium oxide as a main component, and further is doped with a rare earth element. More specifically, the optical element of the present embodiment has a structure in which a rare earth element is dispersed in a medium, that is, in the glass containing titanium oxide as a main component. Since the glass containing titanium oxide as a main component used in the optical element of the present invention can include a high concentration of rare earth element, it exhibits a high intensity upconversion emission characteristic and/or a sufficient light amplifying characteristic. Hereinafter, the glass containing titanium oxide as a main component and containing also a rare earth element used in the optical element of the present invention may be called a titanium-containing oxide glass.

As the rare earth element to be contained in the titanium-containing oxide glass, at least one element selected from Er and Yb can be used, for example, and Yb and Tm may be used in combination. Also, all of Er, Yb and Tm may be contained together. By containing these rare earth elements, the titanium-containing oxide glass can attain upconversion emission with a higher intensity, and an enhanced light amplification effect. Among these rare earth elements, Er is preferable because Er makes it possible to attain effectively the upconversion emission with a higher intensity Moreover, doping with Er and Yb in combination makes it possible to attain upconversion emission with a further higher intensity.

As the titanium-containing oxide glass, a glass further containing Ba, and a glass further containing at least one element selected from La and Nd are used in the present embodiment. As the glass further containing Ba, a glass having a composition of, for example, BaTi₂O₅ as a base composition is used in the present embodiment. As the glass further containing at least one element selected from La and Nd, a glass having a composition of, for example, LaTi₂O_{5.5} or NdTi₂O_{5.5}, as a base composition is used.

For example, in a case where the titanium-containing oxide glass used in the present embodiment further contains Ba and the rare earth element contained in the titanium-containing oxide glass is at least one element selected from Er, Yb, and Tm, a titanium-containing oxide glass is used preferably that has a composition represented substantially by formula Ba₁₋ₓ₁₋ₓ₂₋ₓ₃Erₓ₁Ybₓ₂Tₘₓ₃TiyO_{z}, where x1, x2, x3, y, and z satisfy 0≤x1≤6, 0≤2≤0.3, 0≤x3≤0.3, 1<y<3, and 3.5<z<7.0, and x1, x2, and x3 are not 0 at the same time.

For example, in a case where the titanium-containing oxide glass used in the present embodiment further contains at least one element selected from La and Nd, and the rare earth element contained in the titanium-containing oxide glass is at least one element selected from Er, Yb, and Tm, a titanium-containing oxide glass is used preferably that has a composition represented substantially by formula M₁₋ₓ₁₋ₓ₂₋ₓ₃Erₓ₁Ybₓ₂Tmₓ₃Ti_{y}O_{z}, where M is at least one element selected from La and Nd, x1, x2, x3, y, and z satisfy 0≤x1≤0.6, 0≤x2≤0.3, 0≤x3≤0.3, 1<y<3, and 3.5 < z < 7.0, and x1, x2, and x3 are not 0 at the same time.

In this specification, the term "substantially "means that the titanium-containing oxide glass may include no more than 1 mol%, preferably no more than 0.5 mol%, and more preferably no more than 0.1 mol% of impurities.

However, since the above-mentioned compositions are crystallized and devitrified very easily, it is difficult to vitrify them by usual melting with a crucible. As a technique for vitrifying a composition that is devitrified easily, methods such as a super rapid cooling method using a roller are known. By the super rapid cooling method, however, only powder or microscopic glass pieces (for example, flaky pieces with a thickness of several tens of micrometers) can be obtained. Therefore, as the means to produce a bulk glass usable for the optical element of the present invention, the "levitation method" described below preferably is used.

The present inventors already have proposed in JP 2006-248801 A the levitation method described below.

### <Levitation method>

### (Levitation apparatus)

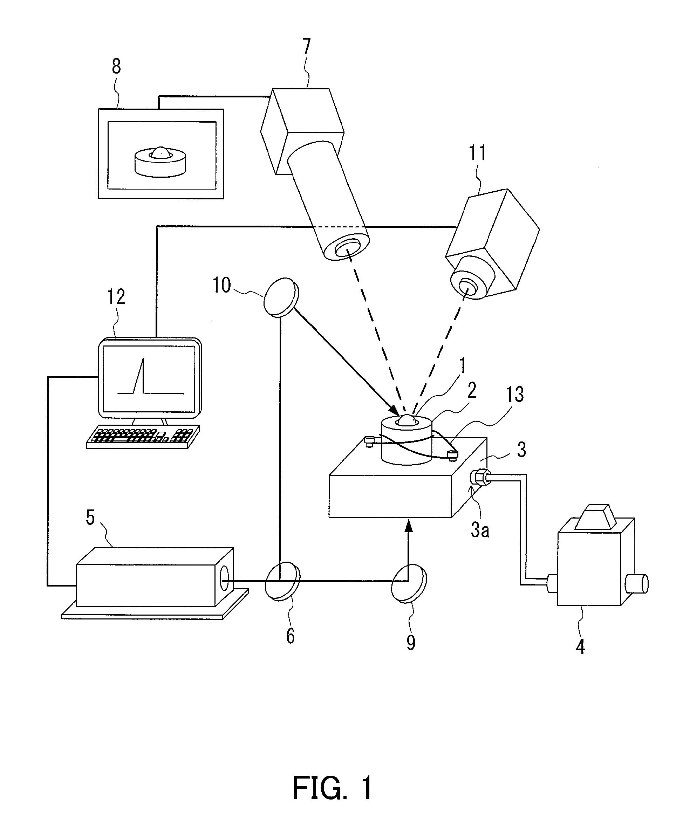

Fig. 1 is a schematic view showing one example of an apparatus (levitation apparatus) for performing a levitation method, used preferably in the production method of the titanium-containing oxide glass.

The levitation apparatus includes: a gas levitation furnace 2 for levitating a raw material 1 in air; an anchorage 3 for preventing movement of the gas levitation furnace 2 and for supplying a levitation gas to the gas levitation furnace 2; a flow-rate adjuster 4 for adjusting a flow rate of the gas to be supplied to the anchorage 3; a carbon dioxide laser 5 that emits a laser beam to heat the levitated raw material 1; a beam splitter 6 that splits the laser beam emitted from the laser 5 into two beams; an imaging unit (here, a CCD camera) 7 and a monitor 8 to monitor the levitation state of the raw material 1; a radiation thermometer 11 to measure a temperature of the raw material 1; and a control unit 12 to control a laser output, etc. of the laser 5.

The gas levitation furnace 2 includes a gas supply channel (not shown) through which the levitation gas for the raw material 1 flows upward (against the direction of the gravitational force). The gas is supplied into the gas supply channel through a nozzle (not shown) provided underneath (at the bottom of the furnace). The gas levitation furnace 2 levitates the raw material 1 in air by the pressure of the flowing gas. The flow rate of the flowing gas is not particularly limited because it is related to factors such as the mass of the raw material. For example, in order to levitate 0.005 g to 0.05 g of the raw material, the gas may flow at a rate of, for example, 0.1 L/min to 0.5 L/min.

The gas levitation furnace 2 is anchored to the anchorage 3 with an anchoring wire 13. The anchorage 3 has a gas supply port 3a. The flow-rate adjuster 4 is connected to the gas supply port 3a of the anchorage 3, and controls the flow rate of the gas to be supplied to the gas levitation furnace 2. The imaging unit 7 and the monitor 8 monitor the levitation state of the raw material 1, and thereby the flow rate of the gas may be adjusted according to the levitation state of the raw material 1.

The raw material 1 is heated to a predetermined temperature while being levitated. A laser beam is used for the heating. The beam splitter 6 splits the laser beam emitted from the carbon dioxide laser 5 into two laser beams of almost equal power. These laser beams respectively are reflected by reflecting mirrors 9 and 10 to be applied to the raw material 1 from top and bottom. The temperature of the raw material 1 is measured by the radiation thermometer 11 in a non-contact manner. The information of the temperature measured by the radiation thermometer 11 is input into the control unit 12. The control unit 12 reads the temperature information, and, according to a predetermined control program, controls the output of the laser, which is a heat source for the raw material 1, so as to control the temperature of the raw material 1.

### (Method for producing glass by the levitation method)

A method for producing glass using the levitation apparatus shown in Fig. 1 will be described. First, the raw material 1 is set in the gas levitation furnace 2, and a gas is sent into the gas levitation furnace 2 to levitate the raw material 1. The levitation gas may be, for example, air, Ar₂, or N₂.

Next, the control unit 14 adjusts the laser output of the carbon dioxide laser 5, and a laser beam then is emitted to heat the raw material 1. While measuring the temperature of the raw material 1 with the radiation thermometer 11, the raw material 1 is heated to at least its melting point, taking into account the evaporation and the complete fusion of the raw material 1. The heating temperature is not particularly limited as long as it is equal to or higher than the melting point of the raw material 1. The heating temperature preferably is a temperature in a range 100°C to 500°C higher than the melting point of the raw material 1.

The levitation state and the melting state of the raw material 1 captured by the imaging unit 7 are monitored on the monitor 8. The gas flow rate and the heating temperature are adjusted accordingly to levitate the melted raw material stably. Here, in order to remove bubbles formed in the melted raw material, the raw material preferably is maintained at a predetermined temperature for a predetermined period of time (several minutes) after the raw material has been melted completely. The predetermined temperature at which the raw material is maintained in a molten state is not particularly limited, and it may be, for example, a temperature in a range 100°C to 500°C higher than the melting point. The period of time for which the molten state is maintained is not particularly limited either, and it may be, for example, 0.5 to 5 minutes.

Next, the melted raw material is cooled at a predetermined rate by adjusting the output of the laser beam applied to the raw material 1 or by turning off the laser beam. This allows the melted raw material to be solidified without undergoing crystallization. Thus, a glass can be obtained. The cooling rate preferably is, for example, 500°C /sec to 1,000°C /sec, and more preferably 1,000°C /sec to 1,500°C /sec.

### (Glass raw material)

The following describes an example of a method for producing a glass raw material for the titanium-containing oxide glass used in the optical element of the present invention.

First, in order to prepare a raw material that allows the titanium-containing oxide glass to obtain a desired composition, raw material powders such as oxide powders are weighed and mixed at a desired weight ratio. For example, in order to prepare 1 g of glass raw material with a composition of Ba_{0.7}Er_{0.3}Ti₂O_{5.15}, 0.43183 g of BaCO₃ powder, 0.16503 g of Er₂O₃ powder, and 0.49932 g of TiO₂ powder are weighed respectively. The weighed raw material powders are wet-blended using ethanol (a first wet-blending) and pre-fired. Specifically, for example, after being dried, the powder blend is placed in an electric furnace and pre-fired at, for example, 1,000°C for 12 hours to be sintered. The pre-fired powder blend is wet-blended again (a second wet-blending), and press-molded into, for example, a rod shape. Then, a solid in a predetermined size is cut out of the molded product, and is subject to a final firing at, for example, 1,250°C for 12 hours to obtain a glass raw material.

Thus, the glass raw material can be prepared. The method for preparing the glass raw material described above is merely an example, and the size of the raw material, and the temperatures and the periods of time for pre-firing and final firing are not limited to the ones described therein.

### <Examples of optical element>

Hereinafter, the optical element of the present invention will be described with a specific example. As mentioned above, the optical element of the present invention can attain a high intensity upconversion emission effect and/or an enhanced light amplifying effect by being irradiated with an excitation light. Therefore, the optical element of the present invention can be used as an optical resonator, a wavelength converting part, and an optical amplifier.

### (Optical resonator)

When using the optical element of the present invention as an optical resonator, it is configured by, for example, processing the titanium-containing oxide glass to have a pair of surfaces facing each other, and disposing a reflective layer on each of the pair of surfaces. When an excitation light is resonated by such an optical resonator, the energy intensity of the excitation light is increased inside the titanium-containing oxide glass, leading to upconversion emission with a higher intensity.

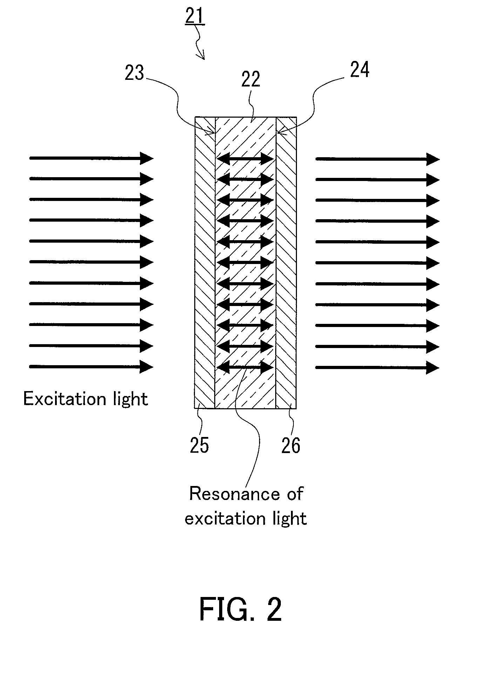

Fig. 2 is a schematic view showing an example in which the optical element of the present invention is used as an optical resonator. An optical resonator 21 is constituted by a glass 22 having two parallel planes 23 and 24, and reflective layers 25 and 26 provided respectively on the planes 23 and 24 of the glass 22. Since the reflective layers 25 and 26 serve as reflective surfaces, the excitation light is confined and resonated within the glass 22. The glass 22 is a glass obtained by processing the titanium-containing oxide glass to have two parallel planes (a pair of surfaces facing each other) as described above. The reflective layers 25 and 26 can be formed of a metal thin film or a periodic dielectric film. The periodic dielectric film is a multilayer film obtained by stacking a dielectric layer with a low refractive index and a dielectric layer with a high refractive index one on another alternately. Resonating the excitation light with the optical resonator 21 increases significantly the energy intensity of the excitation light within the glass 22, leading to upconversion emission with a higher intensity

### (Wavelength converting part)

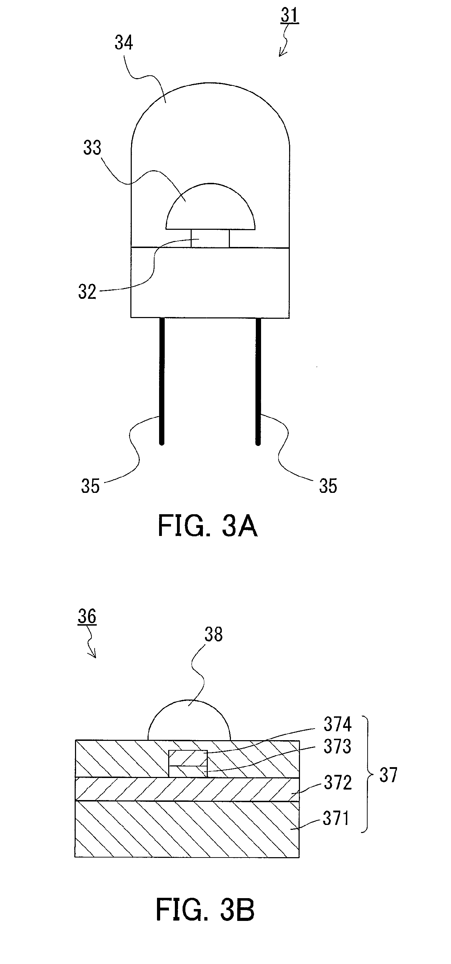

An example of using the optical element of the present invention as a wavelength converting part will be described. Fig. 3A is a schematic view showing a light-emitting device 31 that converts a wavelength of an infrared ray emitted from an infrared light emitting diode (LED) 32 by using a wavelength converting part 33, which is the optical element of the present invention, so as to emit a visible light. The wavelength converting part 33 is made by processing the titanium-containing oxide glass into a hemispherical shape, and is disposed so as to cover a light-emitting portion of the LED 32. The LED 32 and the wavelength converting part 33 are sealed in a sealing part 34. Reference numeral 35 in the figure indicates a lead wire. In the device 31, the wavelength converting part 33 performs the upconversion emission by using, as the excitation light, the infrared ray that has been emitted from the LED 32 and is incident on the wavelength converting part 33, and emits a visible light.

As shown in Fig. 3B, it also is possible to configure a light-emitting device 36 by disposing, as a wavelength converting part 38, the titanium-containing oxide glass processed into a hemispherical shape on an emission point of a VCSEL (Vertical Cavity Surface Emission Laser, a surface-emission-type laser) 37. In the device 36, the wavelength converting part 38 performs the upconversion emission by using, as the excitation light, the laser beam having emitted from the VCSEL 37, and emits a visible light. The VCSEL 37 includes a reflective layer 372, an active layer 373, and a reflective layer 374 stacked on a substrate 371. Stacking the reflective layer 372, the active layer 373, and the reflective layer 374 in this order forms a resonator structure, and thereby the laser beam is oscillated in a direction perpendicular to a surface of the substrate. In the examples shown in Fig. 3A and Fig. 3B, the wavelength converting parts 33 and 38 are hemispherical titanium-containing oxide glasses, but they may be of a flat shape.

### (Microsphere laser)

An example of using the optical element of the present invention as a microsphere laser will be described. The microsphere laser can be obtained by processing the titanium-containing oxide glass into a shape of a sphere with an outer diameter of several tens of micrometers or less. A part of the light generated by the upconversion emission repeats total reflection on an interface between the spherical glass and outside, causing resonance. Thus, the spherical glass can function as a laser. The microsphere laser can be used as a non-contact probe by utilizing a local field present in the vicinity of a surface thereof (Reference: "Denshi Kagaku Kenkyu" (Electronic Science Study), Vol. 6, p. 68 to 69, 1998).

### (White light source)

An example of using the optical element of the present invention as a white light source will be described. The white light source can be obtained by doping the titanium-containing oxide glass with a plurality of addition ingredients that emit lights with three primary colors of red, green, and blue through the upconversion emission, and irradiating the titanium-containing oxide glass with an excitation light. For example, for an excitation light with a wavelength of 980 nm, a combination of Tm and Yb (red and blue), a combination of Er and Yb (red and green), or the like can be considered. It also is possible to emit fluorescent lights of red and green by using a blue light source as the excitation light, and combine them with the blue light source to be white.

For example, in the light-emitting device 31 shown in Fig. 3A, a white light source can be obtained by replacing the infrared LED 32 with a blue LED and doping the glass of the wavelength converting part 33 with addition ingredients that emit red and green lights through the upconversion emission.

### (Optical amplifier)

In the optical element of the present invention, the concentration of the rare earth element in the titanium-containing oxide glass can be increased. Thus, it is possible to process the titanium-containing oxide glass into a fiber and use it in an optical amplifier.

Examples of the optical element of the present invention have been described above. Examples of the optical element of the present invention, however, are not limited to these, and lens, prism, etc. are included as well. The optical element of the present invention includes also elements that can obtain nonlinear optical effects such as SHG (second harmonic generation), THG (third harmonic generation), degenerate four-wave mixing, and a photorefractive phenomenon.

### Examples

Hereinafter, the present invention will be described in more detail using examples.

### (Example 1)

Spherical glass samples each having a base composition of BaTi₂O₅ and further being doped with at least one rare earth element were produced by the levitation method. The samples produced in the present example were glasses having a composition represented by formula Ba₁₋ₓ₁₋ₓ₂₋ₓ₃Erₓ₁Ybₓ₂Ti_{y}O_{z}. As shown in Table 1, Samples 1-1 to 1-4 are glasses obtained by doping the base composition with Er as the rare earth element, and Samples 1-5 to 1-11 are glasses obtained by codoping the base composition with Er and Yb as the rare earth element.

### (Process of producing spherical glass by levitation method)

First, raw material powders were weighed and mixed to obtain the compositions shown in Table 1. The weighed oxide powders and ethanol were put in an agate mortar to be wet-blended (a first wet-blending), and the resulting blend was pre-fired. Specifically, the powder blend was placed in an electric furnace after being dried, and pre-fired at 1,000°C for 12 hours to be sintered. Then, additional ethanol was added to wet-blend the powder blend (a second wet-blending). Subsequently, the powder blend was put in a rubber tube and press-molded into a rod shape under hydrostatic pressure. A solid in a size of approximately 2 mm x 2 mm was cut out of the resultant rod and was subject to a final firing at 1,250°C for 12 hours. Thus, a glass raw material for producing the samples was obtained.

Next, glass samples were produced using the glass raw material obtained as above. In the present example, the levitation apparatus shown in Fig. 1 was used. First, a 2 mm x 2 mm glass raw material was placed in the gas levitation furnace 2 and levitated therein by the pressure of the compressed air gas whose flow rate was adjusted by the flow-rate adjuster 4. Then, the levitated raw material was irradiated with a laser beam, and heated to a temperature equal to or higher than its melting point to be melted.

Here, the temperature of the raw material was measured with the radiation thermometer 11, and furthermore, the melting state of the raw material captured by the imaging unit 7 was shown on the monitor 8. The raw material was heated to an appropriate temperature accordingly, taking into account the evaporation and the melting state of the raw material. The levitation state of the raw material was monitored on the monitor 8 so as to levitate the melted raw material stably. After the raw material was melted completely, the molten state was maintained for 2 minutes to remove bubbles formed in the melted raw material. Thereafter, the laser beam was turned off and the melted raw material was cooled rapidly at a cooling rate of 1,000°C /sec to be solidified. Note that regarding all of the samples shown in Table 1, no exothermic peak due to crystal solidification was observed in cooling curves.

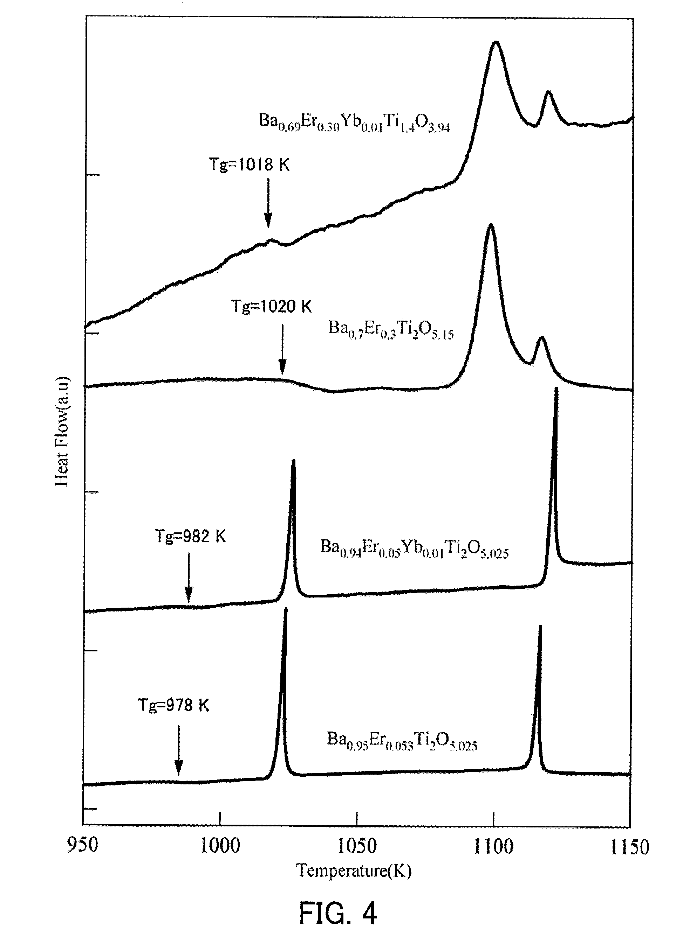

A differential thermal analysis (DTA) was conducted on the samples produced by the above-mentioned method. The DTA results reveal that these samples each had a glass transition point and a crystallization temperature. More specifically, the results reveal that all of the Samples 1-1 to 1-11 of the present example were vitreous at a room temperature. Of the DTA results of the Samples 1-1 to 1-11, those of the Samples 1-2, 1-4, 1-6, and 1-8 are shown in Fig. 4.

### (Method for measuring refractive index and diameter of sample)

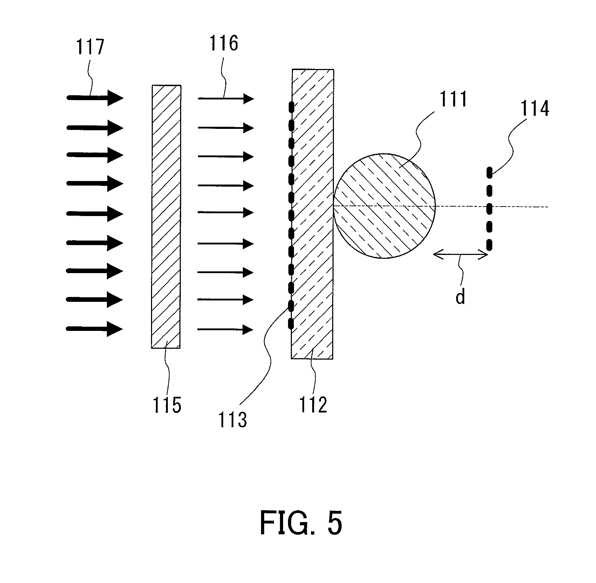

In the present example, the position of a focal point with the sample spherical glass in place was measured to calculate a refractive index of the sample spherical glass. Specifically, as shown in Fig. 5, a spherical glass 111 to be measured was disposed on a glass substrate 112, and a surface of the glass substrate 112 opposite to a surface on which the spherical glass 111 was disposed was irradiated with a light 116 with a predetermined wavelength, so as to measure the position of the focal point from a surface of the spherical glass 111 with a microscope. The measurement of the position of the focal point was conducted by measuring the distance d from the surface of the spherical lens 111 to a pattern image 114, which is an image projected through a pattern 113 formed on the irradiated surface of the glass substrate 112. The light with the predetermined wavelength was obtained by using an interference filter 115 that allows only a light with this wavelength to pass therethrough selectively. In the present example, the refractive indexes were measured at wavelengths of 486 nm, 589 nm, and 658 nm, respectively. Reference numeral 117 in the figure shows white light. An optical thickness of the glass substrate 112 at each measurement wavelength was obtained by measuring, with a microscope, a positional difference between two focal points focused respectively on each of the surfaces of the glass substrate 112.

A diameter of the spherical glass 111 was obtained by measuring a positional difference between two focal points focused respectively on the surface of the glass substrate 112 contacting the spherical glass 111 and on the surface of the spherical glass on the opposite side. The refractive index of the spherical glass was determined through a geometric optics calculation, using the "distance d", the "optical thickness of the glass substrate 112", and the "diameter of the spherical glass 111" thus obtained.

Table 1 shows also the diameters and refractive indexes of the spherical glasses with respective compositions. All the samples were colored pink, and the color was deeper as Er concentration increased. Note that Sample 1-11 could not be measured for the refractive index because of precipitated crystals scattering the light.

**[Table 1]**

| Sample No. | Composition | | | | | | | | Diameter (mm) | Refractive index | | |
|---|---|---|---|---|---|---|---|---|---|---|---|---|
| | Ba | La | Nd | Er | Yb | Tm | Ti | O | | 486nm | 589nm | 658nm |
| | 1-x1-x2-x3 | | | x1 | x2 | x3 | y | z | | | | |
| 1-1 | 0.98 | | | 0.02 | | | 2.00 | 5.010 | 0.807 | 2.173 | 2.150 | 2.136 |
| 1-2 | 0.95 | | | 0.05 | | | 2.00 | 5.025 | 1.336 | 2.212 | 2.175 | 2.141 |
| 1-3 | 0.85 | | | 0.15 | | | 2.00 | 5.075 | 1.178 | 2.227 | 2.174 | 2.149 |
| 1-4 | 0.70 | | | 0.30 | | | 2.00 | 5.150 | 1.659 | 2.053 | 2.023 | 2.004 |
| 1-5 | 0.97 | | | 0.02 | 0.01 | | 2.00 | 5.015 | 0.960 | 2.221 | 2.159 | 2.143 |
| 1-6 | 0.94 | | | 0.05 | 0.01 | | 2.00 | 5.030 | 1.392 | 2.208 | 2.154 | 2.136 |
| 1-7 | 0.84 | | | 0.15 | 0.01 | | 2.00 | 5.080 | 1.271 | 2.194 | 2.177 | 2.148 |
| 1-8 | 0.69 | | | 0.30 | 0.01 | | 1.40 | 3.955 | 1.282 | 2.123 | 2.094 | 2.068 |
| 1-9 | 0.69 | | | 0.30 | 0.01 | | 2.00 | 5.155 | 1.398 | 2.258 | 2.218 | 2.188 |
| 1-10 | 0.54 | | | 0.45 | 0.01 | | 2.00 | 5.230 | 1.010 | 2.289 | 2.255 | 2.225 |
| 1-11 | 0.39 | | | 0.60 | 0.01 | | 2.25 | 5.805 | 1.060 | - | - | - |
| 2-1 | 0.95 | | | | | 0.05 | 2.00 | 5.025 | 1.497 | 2.156 | 2.120 | 2.097 |
| 2-2 | 0.70 | | | | | 0.30 | 2.00 | 5.150 | 1.325 | 2.154 | 2.114 | 2.093 |
| 2-3 | 0.93 | | | | 0.02 | 0.05 | 2.00 | 5.035 | 1.010 | 2.364 | 2.309 | 2.277 |
| 3-1 | 0.95 | | | | 0.05 | | 2.00 | 5.025 | 1.478 | 2.156 | 2.123 | 2.104 |
| 3-2 | 0.90 | | | | 0.10 | | 2.00 | 5.050 | 1.248 | 2.215 | 2.167 | 2.146 |
| 3-3 | 0.70 | | | | 0.30 | | 2.00 | 5.150 | 1.304 | 1.943 | 1.916 | 1.898 |
| 4-1 | | 0.95 | | 0.05 | | | 2.25 | 6.000 | 1.161 | 2.411 | 2.359 | 2.320 |
| 4-2 | | 0.94 | | 0.05 | 0.01 | | 2.25 | 6.000 | 1.187 | 2.385 | 2.338 | 2.322 |
| 4-3 | | 0.54 | | 0.45 | 0.01 | | 2.25 | 6.000 | 0.873 | 2.336 | 2.310 | 2.282 |
| 4-4 | | 0.39 | | 0.60 | 0.01 | | 2.25 | 6.000 | 0.842 | - | 2.339 | 2.329 |
| 4-5 | 0.14 | 0.80 | | 0.05 | 0.01 | | 2.25 | 5.930 | 0.741 | 2.377 | 2.327 | 2.278 |
| 5-1 | | | 0.95 | 0.05 | | | 2.00 | 5.500 | 1.049 | 2.383 | 2.356 | 2.329 |
| 5-2 | | | 0.94 | 0.05 | 0.01 | | 2.00 | 5.500 | 1.112 | 2.425 | 2.388 | 2.333 |

### (Excitation light irradiation and upconversion emission)

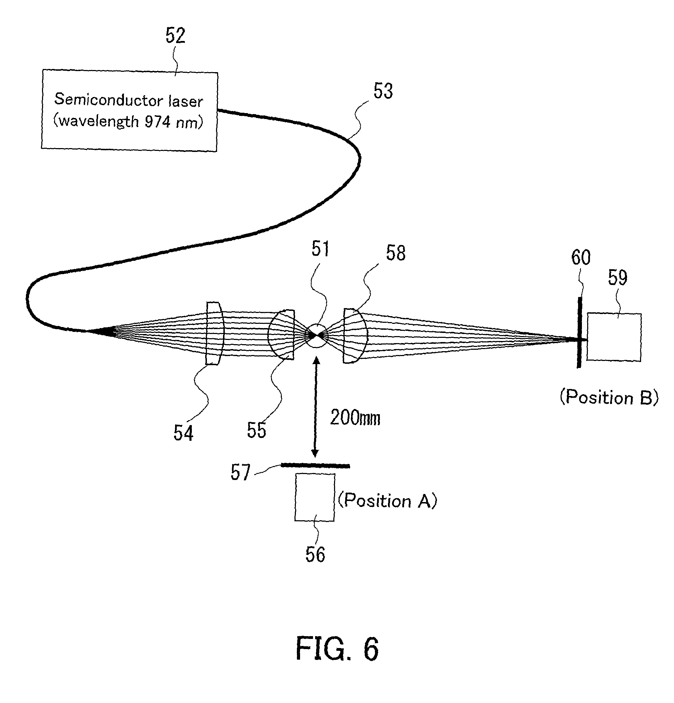

Using the apparatus of Fig. 6, spherical glasses 51 of Samples 1-1 to 1-11 each were irradiated with an excitation light to measure the upconversion emission thereof. Light of a semiconductor laser 52 (with a wavelength of 974 nm, and a maximum current value of 700 mA) was sent into a single mode fiber 53 to serve as an excitation light source. A collimator 54 (focal distance f = 15.3 mm) collimated the light coming out from an end of the single mode fiber 53 into parallel rays. Then, an object lens 55 (focal distance f = 4.5 mm) converged the parallel rays. The intensity of the excitation light at a focal point of the object lens 55 was 300 mW. The spherical glass 51 was placed so that a center thereof almost coincides with the focal point of the object lens 55.

Under the irradiation of the excitation light, a green light generated by Er-induced upconversion emission was emitted from all of the spherical glasses having respective compositions. In Samples 1-1 to 1-11, the intensity of the light emission was highest when Er concentration (x1) was 0.05, and the intensity lowered as the Er concentration was away from this value. The lights emitted from the Yb-doped compositions were brighter than those emitted from the compositions not doped with Yb even when they all were doped with the same concentration of Er. This reveals that Yb has an effect of enhancing the upconversion emission.

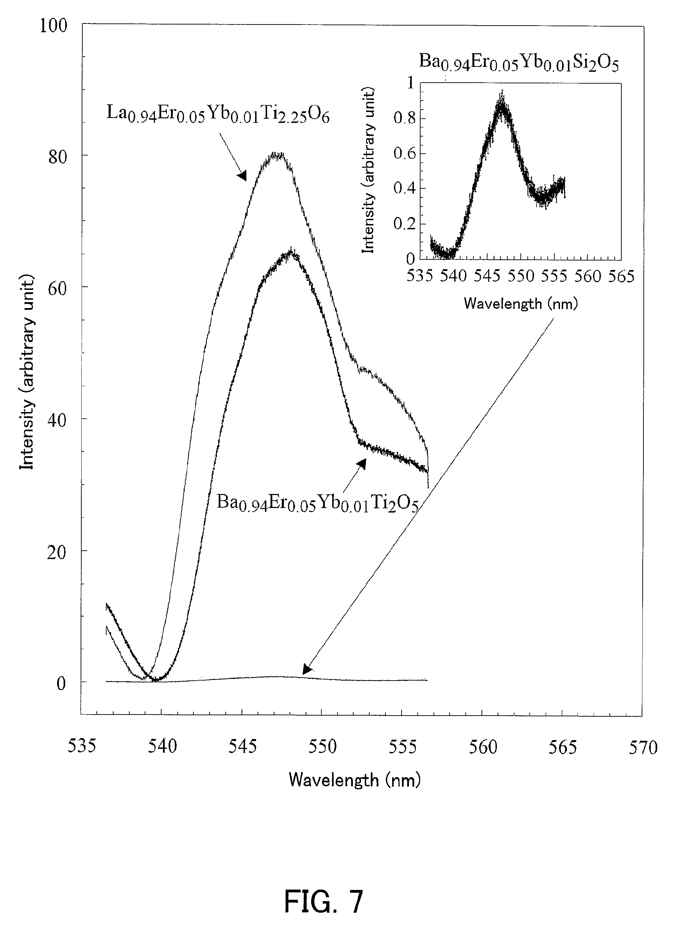

The spherical glass of Sample 1-6 was irradiated with an excitation laser beam with a wavelength of 488 nm by using a Raman microscopic apparatus (triple Raman spectroscopic apparatus T64000 (manufactured by Horiba Ltd.)), and measured for emission spectrum. Fig.7 shows the result thereof. As is apparent from the figure, a light was emitted from Sample 1-6, with a peak at around 548 nm.

### (Example 2)

As in Example 1, spherical glass samples, each having a base composition of BaTi₂O₅ and further being doped with at least one of rare earth elements, were produced by the levitation method. The samples produced in the present example were glasses having a composition represented by formula Ba₁₋ₓ₂₋ₓ₃Ybₓ₂Tmₓ₃Ti_{y}O_{z}. As shown in Table 1, Samples 2-1 and 2-2 were glasses doped only with Tm as the rare earth element, and Sample 2-3 was a glass codoped with Tm and Yb as the rare earth element.

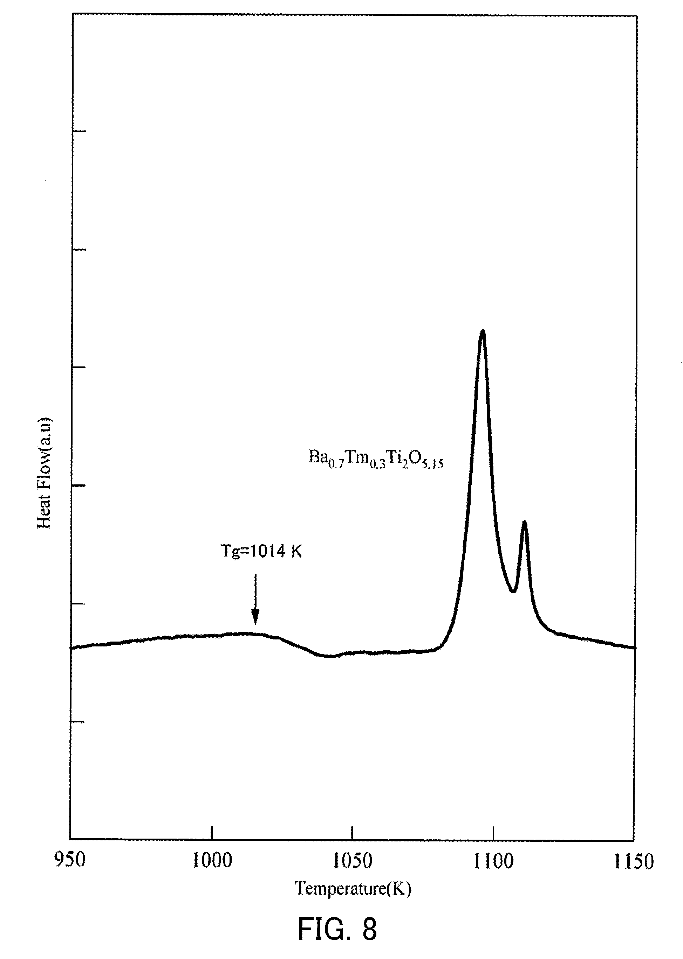

A differential thermal analysis (DTA) was conducted on these samples produced by the above-mentioned method. The results thereof reveal that the samples each had a glass transition point and a crystallization temperature. More specifically, the results reveal that all of the Samples 2-1 to 2-3 of the present example were vitreous at a room temperature. Of the DTA results of the Samples 2-1 to 2-3, the result of the Sample 2-2 is shown in Fig. 8.

Using the same apparatus and the same conditions as in the Example 1, the spherical glasses were irradiated with the excitation light to measure the upconversion emission. Under the irradiation of the excitation light, no light was emitted from Samples 2-1 and 2-2 that had been doped only with Tm. A blue light generated by the upconversion emission was emitted from Sample 2-3 that had been codoped with Yb.

### (Example 3)

As in the Example 1, spherical glass samples, each having a base composition of BaTi₂O₅ and further being doped with a rare earth element, were produced by the levitation method. The samples produced in the present example were glasses having a composition represented by formula Ba₁₋ₓ₂Ybₓ₂TiyO_{z}. More specifically, spherical glasses of Samples 3-1 to 3-3 doped only with Yb as the rare earth element were produced and evaluated (see Table 1).

A differential thermal analysis (DTA) was conducted on these samples produced by the above-mentioned method. Table 9 shows the results. The results reveal that these samples each had a glass transition point and a crystallization temperature. More specifically, the results reveal that all of the Samples 3-1 to 3-3 of the present example were vitreous at a room temperature.

Using the same apparatus and the same conditions as in the Example 1, the spherical glasses were irradiated with the excitation light to measure the upconversion emission. Under the irradiation of the excitation light, a bluish green light was emitted from Samples 3-1 and 3-3, and a blue light was emitted from Sample 3-2.

### (Example 4)

As in the Example 1, spherical glass samples each having a base composition of LaTi₂O₅ and further being doped with a rare earth element were produced by the levitation method. The samples produced in the present example were glasses having a composition represented by formula La₁₋ₓ₁₋ₓ₂Erₓ₁Nbₓ₂Ti_{y}O_{z}. As shown in Table 1, Sample 4-1 was a glass doped only with Er as the rare earth element, Samples 4-2 to 4-4 were glasses codoped with Er and Yb as the rare earth element, and Sample 4-5 was a glass codoped with Er and Yb as the rare earth element and further doped with Ba.

All the samples were colored pink, and the color was deeper as Er concentration increased. The glass of Sample 4-4 could not be measured for the refractive index because it absorbed a large amount of light with a wavelength of 486 nm.

Using the same apparatus and the same conditions as in the Example 1, the spherical glasses were irradiated with the excitation light to measure the upconversion emission. Under the irradiation of the excitation light, a green light generated by Er-induced upconversion emission was emitted from all of the spherical glasses having respective compositions. The intensity of the light was highest when Er concentration (x1) was 0.05, and the intensity lowered as the Er concentration was away from this value. The lights emitted from the Yb-doped compositions were brighter than those emitted from the compositions not doped with Yb even when they all were doped with the same concentration of Er. This reveals that Yb has an effect of enhancing the upconversion emission. Among the Ba-containing compositions (Example 1) and the La-containing compositions (Example 4), comparisons were made between the compositions doped with the same concentration of Er and between the compositions doped with the same concentration of Yb, respectively. As a result, the La-containing compositions emitted lights with higher intensities.

The intensity of the upconversion emission was measured on Sample 4-2 that emitted a light with the highest intensity, by using the apparatus shown in Fig. 6. The upconverted light was emitted in any directions, and the intensity thereof was high in the vicinity of an optical axis. A photosensor 56 (having a circular light sensing portion made of silicon with a diameter of 8 mm) was placed at a position (position A in Fig. 6) vertically 200 mm away from the optical axis to measure the intensity of the upconversion emission. The result was 0.073 µW.

This value was multiplied by a value obtained by (a surface area of the 200 mm-radius sphere)/(an area of the 8 mm-diameter light sensing portion). As a result, a value of 0.73 mW was obtained as "energy emitted uniformly in any directions". Note that a filter 57 that does not allow the excitation light to pass therethrough was placed between the photosensor 56 and the spherical glass 51 to exclude an influence of the excitation light. The filter 57 had a transmittance of 67% when measured at a wavelength of the upconverted light.

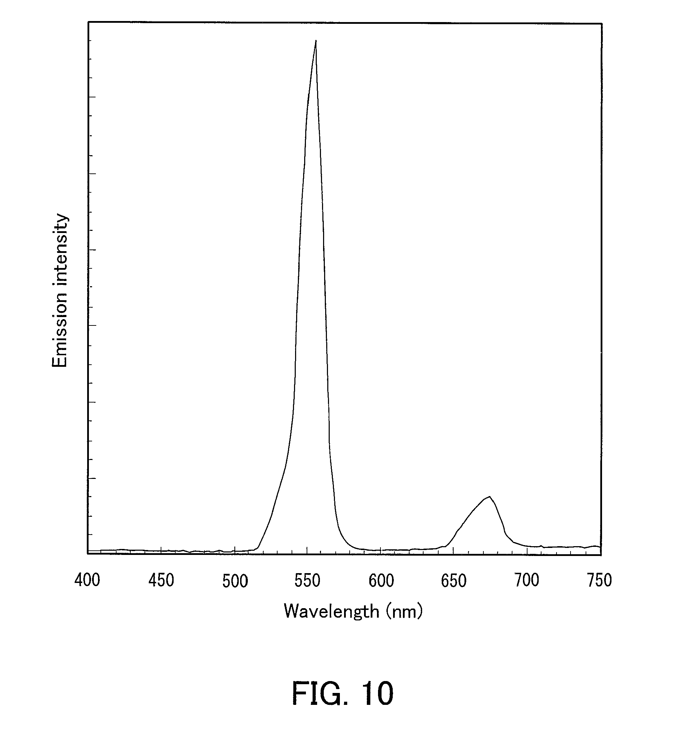

A converging lens (object lens) 58 (numerical aperture NA = 0.45, focal distance 4.5 mm) was placed on the optical axis, and the intensity of "emission energy in the vicinity of the optical axis" was measured with a photosensor 59. The result was 0.16 mW (at position B in Fig. 6). A filter 60 that does not allow the excitation light to pass therethrough was placed between the photosensor 59 and the spherical glass 51 to exclude the influence of the excitation light. The sum of the "energy emitted uniformly in any directions" and the "energy in the vicinity of the optical axis" was taken as the total energy of the upconverted light. After the losses caused by the filters 57 and 60 were compensated, the total energy of the upconverted light was 1.3 mW. Fig. 10 shows a graph of the emission spectrum of Sample 4-5.

Sample 4-2 was measured for emission spectrum by being irradiated with an excitation laser beam with a wavelength of 488 nm, by using a Raman microscopic apparatus (triple Raman spectroscopic apparatus T64000 (manufactured by Horiba Ltd.)). Fig.7 shows also the result thereof. As is apparent from the figure, a light was emitted from Sample 4-2, with a peak at around 547 nm.

### (Example 5)

As in the Example 1, spherical glass samples each having a base composition of NdTi₂O_{5.5} and further being doped with at least one of rare earth elements were produced by the levitation method. The samples produced in the present example were glasses having a composition represented by formula Nd₁₋ₓ₁₋ₓ₂Erₓ₁Ybₓ₂Ti_{y}O_{z}. As shown in Table 1, Sample 5-1 was doped with Er as the rare earth element, and Sample 5-2 was codoped with Er and Yb as the rare earth element. The evaluation results were as shown in Table 1.

Using the same apparatus and the same conditions as in the Example 1, the spherical glasses were irradiated with the excitation light to measure the upconversion emission. A green light was emitted under the excitation light irradiation, but the intensity of the light was not so high as those of the lights emitted from the Ba-containing compositions (Example 1) and the La-containing compositions (Example 4).

### (Example 6)

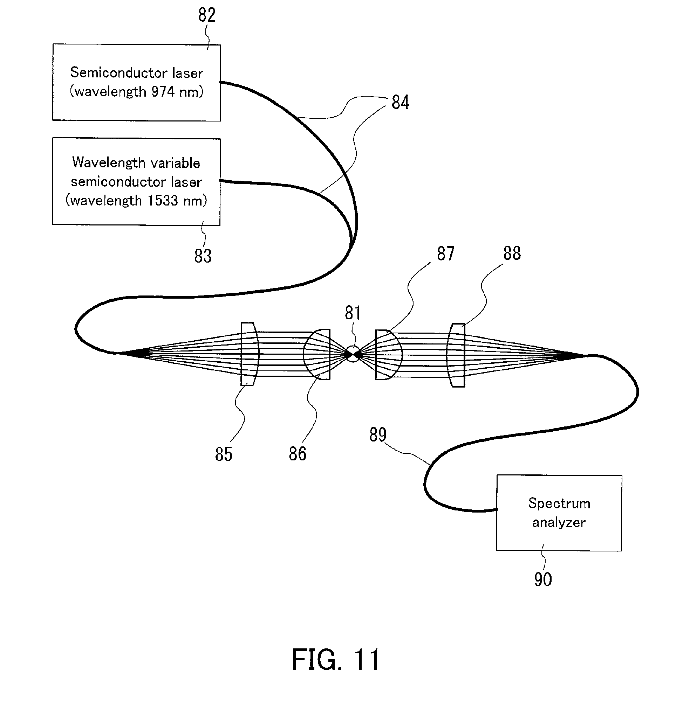

A signal light and the excitation light were sent into the same optical fiber, and the amplification of the signal light through a spherical glass 81 was measured by using the apparatus shown in Fig. 11. A fiber coupler 84 combined the excitation light coming from a semiconductor laser 82 (with a wavelength of 974 nm and a maximum current value of 700 mA) with the signal light coming from a wavelength variable semiconductor laser 83. A collimator 85 (focal distance f = 15.3 mm) collimated the light coming out from an end of the fiber coupler 84 into parallel rays. Then, an object lens 86 (focal distance f = 4.5 mm) converged these parallel rays. The intensity of the excitation light at a focal point was 300 mW when the current value of the semiconductor laser 82 was 700 mA. The spherical glass 81 (1.104 mm in diameter) having the same composition as that of Sample 1-6 produced in the Example 1 was placed so that a center thereof agrees with the focal point of the object lens 86.

An object lens 87 (focal distance f = 4.5 mm) collimated the light that had passed through the spherical glass 81 into parallel rays. A collimator 88 (focal distance f = 15.3 mm) converged these parallel rays and sent them into a multimode fiber 89. The light emitted from an end of the multimode fiber 89 was sent to a spectrum analyzer 90 (Type Q8384, manufactured by Advantest Corp.) to be measured for intensity at each wavelength.

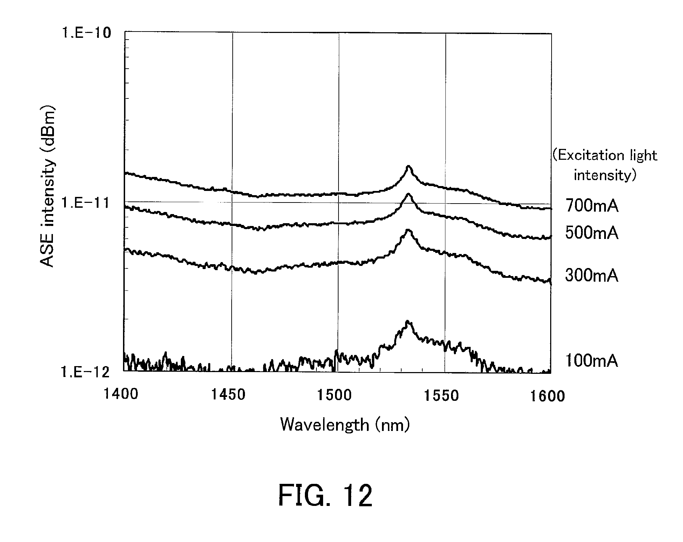

Fig. 12 shows ASE (Amplified Spontaneous Emission) when the spherical glass was irradiated only with the excitation light. The excitation light intensities (the current values of the semiconductor laser 82 shown in Fig. 11) used were 100 mA, 300 mA, 500 mA, and 700 mA. The peak of Er-induced light emission was observed around the wavelength of 1530 nm. Accordingly, the light amplifying effect is likely to be attained in a wavelength range around it.

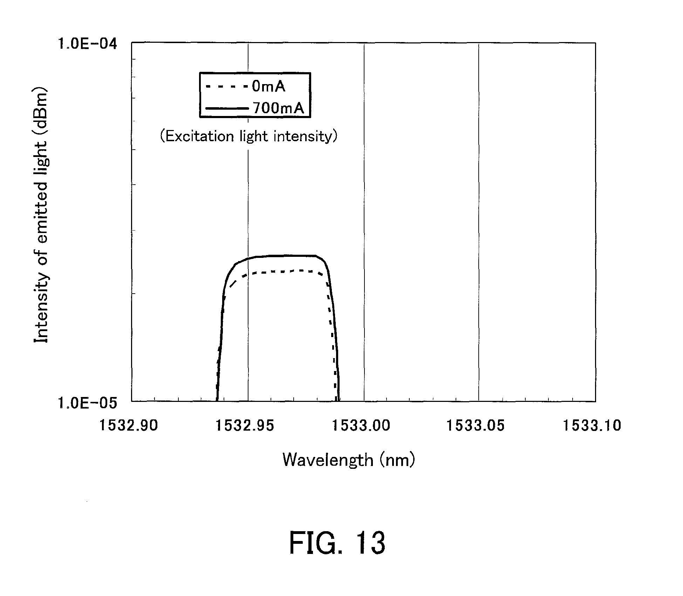

Fig. 13 shows the intensities of the signal lights emitted when the spherical glass was irradiated with the signal light (with a wavelength of 1533 nm, and the intensity at the light source (the wavelength variable laser 83 shown in Fig. 11) was 1 mW) and the excitation light (the current value of the semiconductor laser 82 shown in Fig. 11 was 700 mA), and when the spherical glass was irradiated only with the signal light (the current value of the semiconductor laser 82 shown in Fig. 11 was 0 mA). The excitation light irradiation amplified the signal light by 0.5 dB.

In the apparatus shown in Fig. 11, the amount of the amplification was small because a portion in which energy density was high was observed only in the vicinity of the focal point as the amplifying effect increased. However, a larger amount of the light amplification can be attained when the glass is formed into the shape of fiber or a waveguiding structure is formed by micro processing, and the optical path length is extended at the portion in which the energy density is high.

### (Comparative Example)

For comparison, a silica-containing oxide glass having a composition of Ba_{0.94}Er_{0.05}Yb_{0.01}Si₂O₅ was produced by the levitation method as in the above-mentioned Examples. This comparison sample was irradiated with an excitation laser beam having a wavelength of 488 nm by using a Raman microscopic apparatus (triple Raman spectroscopic apparatus T64000 (manufactured by Horiba Ltd.)) to measure an emission spectrum. Fig. 7 also shows the result thereof. As apparent from the figure, a light slightly was emitted from the silica-containing oxide glass, with a peak around 547 nm. The intensity of the light emission was approximately 1/100 of that of the titanium-containing oxide glass of the present invention.

### Industrial Applicability

The optical element of the present invention can attain a high intensity upconversion emission effect and/or a sufficient light amplifying effect and has high durability. Thereby, the optical element of the present invention can be applied to various optical components such as light sources and optical amplifiers.

## Claims

1. An optical element that exhibits at least one of an upconversion emission characteristic and a light amplifying characteristic when irradiated with an excitation light,
wherein the optical element includes a bulk glass that contains titanium oxide as a main component, and the glass further contains a rare earth element.

2. The optical element according to claim 1, wherein the glass contains at least one element selected from Er and Yb as the rare earth element.

3. The optical element according to claim 1, wherein the glass contains Yb and Tm as the rare earth element.

4. The optical element according to claim 1, wherein the glass further contains at least one element selected from La and Nd.

5. The optical element according to claim 4, wherein the glass has a composition represented substantially by formula M₁₋ₓ₁₋ₓ₂₋ₓ₃Erₓ₁Ybₓ₂Tmₓ₃TiyO_{z}, where M denotes at least one element selected from La and Nd,
x1, x2, x3, y, and z satisfy
0≤x1≤0.6,
0≤x2≤0.3,
0≤x3≤0.3,
1 < y < 3, and
3.5 < z < 7.0, and
x1, x2, and x3 are not 0 at the same time.

6. The optical element according to claim 1, wherein the glass further contains Ba.

7. The optical element according to claim 6, wherein the glass has a composition represented substantially by formula Ba₁₋ₓ₁₋ₓ₂₋ₓ₃Erₓ₁Ybₓ₂Tmₓ₃Ti_{y}O_{z}, where x1, x2, x3, y, and z satisfy
0≤x1≤0.6,
0≤x2≤0.3,
0≤x3≤0.3,
1<y<3,and
3.5 < z < 7.0, and
x1, x2, and x3 are not 0 at the same time.

8. The optical element according to claim 6, wherein the glass further contains at least one element selected from La and Nd.

9. The optical element according to claim 1, that performs upconversion emission when irradiated with the excitation light,
wherein the bulk glass has a pair of parallel surfaces facing each other, and a reflective layer is disposed on each of the pair of parallel surfaces.

10. A titanium-containing oxide glass that is a bulk glass containing titanium oxide as a main component, the titanium-containing oxide glass further containing a rare earth element.

11. The optical element according to claim 10, containing at least one element selected from Er and Yb as the rare earth element.

12. The optical element according to claim 10, containing Yb and Tm as the rare earth element.

13. The titanium-containing oxide glass according to claim 10, further containing at least one element selected from La and Nd.

14. The titanium-containing oxide glass according to claim 13, having a composition represented substantially by formula M₁₋ₓ₁₋ₓ₂₋ₓ₃Erₓ₁Ybₓ₂Tmₓ₃Ti_{y}O_{z}, where M denotes at least one element selected from La and Nd,
x1, x2, x3, y, and z satisfy
0≤x1≤0.6,
0≤x2≤0.3,
0≤x3≤0.3,
1 < y < 3, and
3.5 < z < 7.0, and
x1, x2, and x3 are not 0 at the same time.

15. The titanium-containing oxide glass according to claim 10, further containing Ba.

16. The titanium-containing oxide glass according to claim 15, having a composition represented substantially by formula Ba₁₋ₓ₁₋ₓ₂₋ₓ₃Erₓ₁Nbₓ₂Tmₓ₃Ti_{y}O_{z}, where x1, x2, x3, y, and z satisfy
0≤x1≤0.6,
0≤x2≤0.3,
0≤x3≤0.3,
1 < y < 3, and
3.5<z<7.0, and
x1, x2, and x3 are not 0 at the same time.

17. The titanium-containing oxide glass according to claim 15, further containing at least one element selected from La and Nd.

18. A light emitting method using the titanium-containing oxide glass according to claim 10,
wherein the titanium-containing oxide glass is irradiated with an excitation light so that light emission by an upconversion effect of the titanium-containing oxide glass is attained.

19. A light amplifying method using the titanium-containing oxide glass according to claim 10,
wherein the titanium-containing oxide glass is irradiated with an excitation light so that a light amplifying effect of the titanium-containing oxide glass amplifies a light that is incident on the titanium-containing oxide glass.
